# EUROPÄISCHE PATENTSCHRIFT

(11) **EP 2 842 389 B1**
(45) Veröffentlichungstag und Bekanntmachung des Hinweises auf die Patenterteilung: **06.07.2016**
(21) Anmeldenummer: 13719094.8
(22) Anmeldetag: 26.04.2013
(51) Int. Cl.: H05B 37/03, H05B 33/08, H05B 37/02, G01R 31/44

(54) **ANORDNUNG UND VERFAHREN ZUR BEURTEILUNG DES ZUSTANDS EINER ZU BELEUCHTUNGSZWECKEN VERWENDETEN ELEKTRONISCHEN EINHEIT**
ASSEMBLY AND METHOD FOR EVALUATING THE STATE OF AN ELECTRONIC UNIT USED FOR ILLUMINATION PURPOSES
SYSTÈME ET PROCÉDÉ D'ÉVALUATION DE L'ÉTAT D'UN ENSEMBLE ÉLECTRONIQUE UTILISÉ À DES FINS D'ÉCLAIRAGE

(30) Priorität: 26.04.2012 DE 102012206891
(43) Veröffentlichungstag der Anmeldung: 04.03.2015
(73) Patentinhaber: Zumtobel Lighting GmbH, 6850 Dornbirn (AT)
(72) Erfinder: BÖHNEL, Michael, A-6850 Dornbirn (AT)
(74) Vertreter: Thun, Clemens
(86) Internationale Anmeldenummer: PCT/EP2013/058722
(87) Internationale Veröffentlichungsnummer: WO 2013/160446

(56) Entgegenhaltungen:
- EP-A2- 1 341 402
- DE-A1-102008 059 635
- DE-A1-102009 056 809

## Beschreibung

Die vorliegende Erfindung betrifft eine Anordnung, mit deren Hilfe der Zustand einer zu Beleuchtungszwecken verwendeten elektronischen Einheit beurteilt werden kann. Ferner betrifft die vorliegende Erfindung ein entsprechendes Verfahren. Ein besonders bevorzugtes Anwendungsbeispiel für die vorliegende Erfindung stellt dabei die Beurteilung des Zustands von Lichtquellen auf LED-Basis, insbesondere von LED-Modulen oder OLED-Modulen dar.

Aufgrund der Weiterentwicklung in den letzten Jahren finden zunehmend auch zu Beleuchtungszwecken LED-Lichtquellen Verwendung. Waren früher derartige Lichtquellen hinsichtlich ihrer Lichtstärke nicht ausreichend, um für eine zufriedenstellende Ausleuchtung eines zu beleuchtenden Bereichs zu sorgen, können nunmehr in nahezu sämtlichen Gebieten herkömmliche Lichtquellen wie beispielsweise Leuchtstofflampen oder dergleichen durch Lichtquellen auf LED-Basis ersetzt werden. Dabei bieten derartige LED-Lichtquellen oftmals auch den Vorteil, dass sie hinsichtlich ihrer Lichtabgabe besser veränderbar, beispielsweise dimmbar sind. Auch eröffnen mehrfarbige LED-Lichtquellen nunmehr die Möglichkeit, die Farbe oder Farbtemperatur des abgegebenen Lichts nahezu beliebig einstellen zu können.

Ein weiterer Vorteil von LED-Lichtquellen besteht darin, dass diese eine verhältnismäßig lange Lebensdauer aufweisen, was zumindest für den von der Lichtquelle abgegebenen bzw. über die Lichtquelle erzielbaren Lichtstrom gilt. Tatsächlich allerdings besitzen selbstverständlich auch derartige Lichtquellen eine begrenzte Lebensdauer, welche von der Art und Weise des Betreibens der Lichtquelle bzw. dem Betriebszustand und der Ansteuerung der Lichtquelle abhängt. Aufgrund der immer mehr zunehmenden Verwendung von Leuchten auf LED-Basis ist zu erwarten, dass in Zukunft auch vor Ort ein Wechsel bzw. ein Austausch defekter LED-Lichtquellen bzw. ein Austausch der vollständigen Leuchte erforderlich sein wird.

Da im Vergleich zu klassischen Lichtquellen wie Glühbirnen oder Leuchtstofflampen bei LED-Lichtquellen ein Austausch defekter Einheiten in der Regel nur durch Fachpersonal durchgeführt werden kann, wäre es wünschenswert, einen sich ankündigenden endgültigen Ausfall einer derartigen Lichtquelle möglichst frühzeitig erkennen zu können. Bislang bestehen hierzu allerdings relativ wenige Möglichkeiten, d.h., kleinere Fehler bzw. Defekte im Betrieb der LED-Lichtquelle werden erst zu einem Zeitpunkt bemerkt, zu dem die Lichtquelle vollständig ausfällt. Langsame Veränderungen von Parametern, die zu einem späteren Zeitpunkt zu einem Schaden und damit einem Totalausfall der Lichtquelle führen können, können bislang allerdings nicht vorzeitig erkannt werden. Dies ist bei derartigen LED-Lichtquellen deshalb problematisch, da - wie bereits erwähnt - ein Austausch einer defekten Lichtquelle in der Regel nicht durch den Endbenutzer selbst sondern lediglich durch Fachpersonal durchgeführt werden kann und dementsprechend möglicherweise bis zum endgültigen Austausch eine verhältnismäßig große Zeit vergeht.

Aus der DE 10 2009 056 809 A1 ist eine Leuchtreklame mit LEDs und aus der EP 1 341 402 A2 ist eine Beleuchtungsanordnung mit einem LED-Modul bekannt, wobei bei beiden verschiedene Parameter der LEDs bzw. des LED-Moduls erfasst werden können.

Der vorliegenden Erfindung liegt deshalb die Aufgabenstellung zugrunde, eine neuartige Lösung anzugeben, welche eine Beurteilung des Zustands einer entsprechenden Lichtquelle auf LED-Basis ermöglicht, um ggf. sich anbahnende Fehlzustände oder Probleme, die zu einem Totalausfall der Lichtquelle führen könnten, möglichst frühzeitig zu erkennen.

Die Aufgabe wird durch eine Anordnung zur Beurteilung des Zustands einer zu Beleuchtungszwecken verwendeten elektronischen Einheit mit den Merkmalen des Anspruchs 1 sowie durch ein Verfahren gemäß Anspruch 10 gelöst. Vorteilhafte Weiterbildungen der Erfindung sind Gegenstand der abhängigen Ansprüche.

Vorab sei erwähnt, dass entsprechend dem oben geschilderten Problem ein besonders bevorzugtes Anwendungsbeispiel der vorliegenden Erfindung in der Beurteilung des Zustands einer LED-Lichtquelle besteht. Das erfindungsgemäße Konzept ist allerdings nicht auf diesen speziellen Anwendungsfall beschränkt sondern kann immer dann zum Einsatz kommen, wenn elektronische Einheiten beurteilt werden sollen, die zu Beleuchtungszwecken verwendet werden. Es kann sich hierbei um ein Leuchtmittel, insbesondere um ein LED-Modul, ein OLED-Modul, eine Halogenlampe, eine Gasentladungslampe oder eine Leuchtstofflampe handeln. Darüber hinaus könnte allerdings auch der Zustand anderer elektronischer Einheiten, beispielsweise von Betriebsgeräten zum Betreiben eines Leuchtmittels oder eines Bediengeräts zum Ansteuern von Leuchten bzw. Betriebsgeräten für Leuchtmittel gemäß dem erfindungsgemäßen Konzept beurteilt werden.

Dieses erfindungsgemäße Konzept beruht auf dem Gedanken, im Rahmen einer Zustandsüberwachung eine möglichst umfangreiche Beurteilung des Zustands der zu beurteilenden elektronischen Einheit vorzunehmen. Dabei werden erfindungsgemäß in einem ersten Schritt mehrere, den aktuellen Zustand der elektronischen Einheit repräsentierende physikalische Parameter bzw. Rohdaten erfasst, wobei diese erfassten Rohdaten dann in einem weiteren Schritt ggf. nach entsprechender mathematischer Aufbereitung oder Analyse allein oder in Kombination mit vorgegebenen Referenzwerten bzw. Referenzräumen verglichen werden, wobei die Referenzwerte bzw. Referenzräume zumindest teilweise abgestuft sind. Auf Basis dieser Vergleiche wird dann abschließend eine den Zustand der zu beurteilenden elektronischen Einheit beschreibende Information erstellt.

Im Rahmen dieser erfindungsgemäßen Zustandsüberwachung und -bewertung ist es möglich, detaillierte Informationen hinsichtlich von Fehlzuständen zu erhalten, welche sich zwar möglicherweise nicht unmittelbar auf die Funktionsfähigkeit der zu beurteilenden elektronischen Einheit auswirken, allerdings evtl. in einem absehbarem Zeitraum zu einem gravierenden Fehler führen können. Bei dem eingangs beschriebenen Anwendungsbeispiel der Überwachung von LED-Lichtquellen bedeutet dies, dass bereits vor einem endgültigen Ausfall der Lichtquelle festgestellt werden kann, dass diese fehlerbehaftet ist. Im Rahmen zyklischer Wartungsarbeiten kann dann eine entsprechend fehlerhafte Lichtquelle ersetzt werden, bevor diese vollständig ausfällt. Es ist offensichtlich, dass dies zu deutlichen Vorteilen führt im Vergleich zu einer Vorgehensweise, bei der erst nach endgültigem Ausfallen der Lichtquelle Wartungsmaßnahmen initiiert werden.

Die letztendlich erfindungsgemäß erstellte Information, welche den Zustand der zu beurteilenden elektronischen Einheit beschreibt, erfolgt - wie bereits erwähnt - auf Basis der Vergleiche zwischen den erfassten und evtl. aufbereiteten physikalischen Parametern und vorgegebenen Referenzwerten bzw. Referenzräumen. Diese Vergleichsergebnisse können dabei gemäß einer vorteilhaften Weiterbildung der Erfindung unterschiedlich stark gewichtet werden, da sich Abweichungen von den Referenzwerten bzw. Referenzräumen bzgl. unterschiedlicher Parameter unterschiedlich stark auf den Zustand der zu beurteilenden elektronischen Einheit auswirken können. Ferner wird durch die zumindest teilweise abgestuften Referenzwerte bzw. Referenzräume auch der Grad der Abweichung berücksichtigt.

Diese Referenzwerte bzw. Referenzräume, welche Ausgangsbasis für die Beurteilung des Zustands der zu beurteilenden elektronischen Einheit sind, werden dabei vorzugsweise zu Beginn festgelegt. Insbesondere können diese Werte bzw. Räume auf Basis von Messergebnissen festgelegt werden, welche bei Herstellung bzw. unmittelbar nach Herstellung der zu beurteilenden elektronischen Einheit erhalten wurden. Diese Räume bzw. Werte beruhen also auf dem Ausgangszustand der elektronischen Einheit, bei dem in der Regel der ideale Betriebszustand der Einheit erreicht wird. Dabei kann vorgesehen sein, dass die Referenzwerte bzw. Referenzräume dauerhaft unverändert bleiben. Auf der anderen Seite kann sich der Idealzustand einer zu beurteilenden elektronischen Einheit über deren Lebensdauer hinweg durchaus verändern, was beispielsweise auf Alterungserscheinungen oder dergleichen zurückzuführen ist. Gemäß einem besonders bevorzugten Ausführungsbeispiel kann dementsprechend die Anordnung auch dazu ausgebildet sein, die zum Vergleichen herangezogenen Referenzwerte bzw. Referenzräume selbstständig zu modifizieren.

Die zur Beurteilung des Zustands der elektronischen Einheit herangezogenen physikalischen Parameter werden im Rahmen von Messungen erhalten, wobei hierzu die erfindungsgemäße Anordnung entweder selbst entsprechende Mittel aufweist oder dazu ausgebildet ist, mit entsprechenden Sensoren oder Messeinrichtungen verbunden zu werden. Bei den erfassten physikalischen Parametern kann es sich insbesondere um Temperatur-, Spannungs-, Strom-, Lichtstrom-, Helligkeits-, Farb-, Frequenz-, und/oder Zeitwerte, aber auch spektrale Komponenten wie beispielsweise Amplitudenwerte bei bestimmten Frequenzen handeln. Dies hängt insbesondere auch von dem Typ der zu beurteilenden elektronischen Einheit ab. Die Anordnung zur Beurteilung kann dabei ein separates Bauteil darstellen oder integraler Bestandteil der zu beurteilenden Einheit sein.

Nachfolgend soll die Erfindung anhand der beiliegenden Zeichnung näher erläutert werden. Es zeigen:
- Figur 1: schematisch ein Anwendungsbeispiel der vorliegenden Erfindung, bei dem der Zustand einer LED-Lichtquelle beurteilt wird;
- Figur 2: schematisch das Zusammenwirken der erfindungsgemäßen Anordnung mit der zu beurteilenden LED-Lichtquelle und
- Figur 3: ein Beispiel für die Erstellung eines in die abschließende Beurteilung des Zustands einfließenden Vergleichsergebnisses.

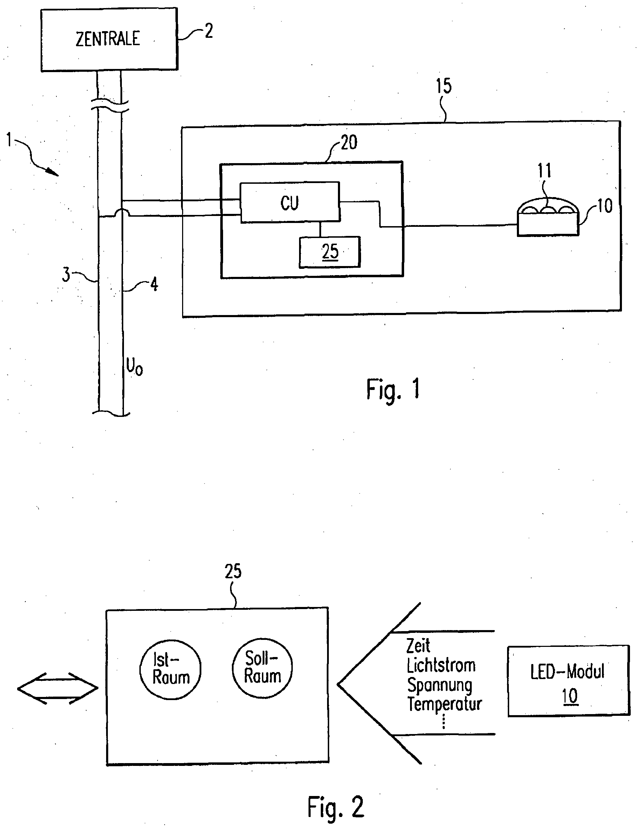

Bei dem in Figur 1 dargestellten Anwendungsbeispiel für die vorliegende Erfindung soll der Zustand einer Lichtquelle auf LED-Basis überwacht und beurteilt werden. Diese mit dem Bezugszeichen 10 versehene Lichtquelle wird durch ein LED-Modul gebildet, welches beispielsweise mehrere LEDs 11 von unterschiedlicher Farbe aufweist. Durch eine entsprechende Ansteuerung der Helligkeit der verschiedenfarbigen LEDs 11 des Moduls 10 kann hierbei ein in seiner Gesamtfarbe bzw. -farbtemperatur einstellbares Licht erhalten werden.

Das LED-Modul 10 ist im vorliegenden Fall Bestandteil einer Leuchte 15, die wiederum Bestandteil eines größeren Beleuchtungssystems 1 ist. Dieses weist eine zentrale Steuereinrichtung 2 auf, welche über eine Busleitung 3 mit den Leuchten 15 des Systems 1 verbunden ist. Die Leuchte 15 weist hierzu intern ein Betriebsgerät 20 auf, welches einerseits für eine Kommunikation mit der zentralen Steuereinheit 2 über das Bussystem 3 zuständig ist und andererseits das LED-Modul 10 ansteuert. Insbesondere kann das Betriebsgerät 20 in bekannter Weise dazu ausgebildet sein, auf Basis von vorhandenen Steuerbefehlen eine über die allgemeine Stromversorgung 4 zur Verfügung gestellte Versorgungsspannung U₀ in eine geeignete Betriebsspannung zum Betreiben des LED-Moduls 10 bzw. deren einzelner LEDs 11 umzusetzen.

Wie eingangs erwähnt, besteht bei entsprechenden Lichtquellen auf LED-Basis das Problem, dass bislang fehlerhafte Betriebszustände nicht zuverlässig erkannt werden konnten, sofern sich diese nicht unmittelbar auf die Funktionsfähigkeit des LED-Moduls 10 auswirkten. Zwar war selbstverständlich ein Totalausfall der Lichtquelle erkennbar, allerdings war es nicht möglich, vorab einen sich anbahnenden Ausfall zu identifizieren und dementsprechend rechtzeitig entsprechende Wartungsmaßnahmen, beispielsweise einen Austausch des LED-Moduls 10 vorzunehmen.

Mit der erfindungsgemäßen Lösung soll dieses Problem nunmehr vermieden werden. Hierzu ist vorgesehen, dass eine Einheit zum Beurteilen des Zustands des LED-Moduls 10 zum Einsatz kommt. Diese Überwachungs- bzw. Beurteilungseinheit 25 ist im vorliegenden Beispiel integraler Bestandteil des Betriebsgeräts 20, sie könnte allerdings auch getrennt hiervon in der Leuchte 15 angeordnet oder als vollkommen eigenständige Einheit, also getrennt von dem Betriebsgerät 20 und der Leuchte 15 ausgebildet werden. Aufgabe dieser Einheit 25 ist es, kontinuierlich oder in regelmäßigen Abständen den Zustand des LED-Moduls 10 zu beurteilen und hieraus eine entsprechende Information zu generieren. Diese kann dann ggf. von dem Betriebsgerät 20 an die zentrale Steuereinheit 2 übermittelt werden. Stellt beispielsweise die Einheit 25 fest, dass in näherer Zeit mit einem Ausfall des LED-Moduls 10 zu rechnen ist, so wird diese Information dann an die Zentrale 2 weitergeleitet, welche entsprechende Wartungsmaßnahmen einleiten kann. Alternativ zu dieser Rückmeldung über das Betriebsgerät 20 wäre es allerdings auch denkbar, dass entsprechende Informationen anderweitig übertragen werden. Dies könnte beispielsweise auch drahtlos oder auf optischem Wege erfolgen, wobei dann die Einheit 25 mit entsprechenden Kommunikationsmitteln ausgestaltet ist.

Das generelle Zusammenwirken zwischen der Beurteilungseinheit 25 und dem LED-Modul 10 sowie die Funktionsweise der erfindungsgemäßen Einheit 25 soll nachfolgend anhand von Figur 2 näher erläutert werden. Im Wesentlichen erfolgt die Beurteilung des Zustands des LED-Moduls 10 in mehreren aufeinanderfolgenden Schritten. Dabei werden in einem ersten Schritt Rohdaten für die spätere Beurteilung des Zustands des LED-Moduls 10 gesammelt. Dies erfolgt insbesondere dadurch, dass physikalische Parameter des LED-Moduls 10 durch die Einheit 25 erfasst werden, was schematisch durch den entsprechenden Pfeil verdeutlicht wird. Hierfür kann die Einheit 25 entsprechende Messeinrichtungen bzw. Sensoren aufweisen oder zumindest mit entsprechenden Sensoren verbunden sein, um die Parameter zu erfassen. Dabei kann es sich um unterschiedlichste Parameter wie beispielsweise Zeit, Lichtstrom, Spannung, Temperatur usw. handeln, wobei je nach Art der zu beurteilenden elektronischen Einheit unterschiedliche Parameter überwacht werden. Das Erfassen dieser physikalischen Parameter kann dabei kontinuierlich oder regelmäßig in bestimmten zeitlichen Abständen erfolgen. Auch ein Erfassen der Parameter jeweils beim Aktivieren der LED-Lichtquelle wäre denkbar.

Die auf diesem Wege in dem ersten Schritt erhaltenen physikalischen Parameter stellen wie bereits gesagt die Rohdaten für die spätere Beurteilung des Zustands des LED-Moduls 10 dar. In einem darauf folgenden zweiten Schritt werden aus den erfassten Rohdaten durch mathematische Berechung, Umwandlung oder Analyse Merkmale generiert. Es ist aber auch denkbar, dass die Rohdaten selbst, ohne weitere Verarbeitung, Merkmale darstellen. Sodann werden in einem dritten Schritt Merkmale zu einem Merkmalsvektor zusammengefasst, der das Zusammenwirken bzw. die Abhängigkeit der physikalischen Werte untereinander darstellt. Es ist auch denkbar, dass ein einzelnes Merkmal einen Merkmalsvektor bildet. Folglich können Merkmalsvektoren ein-, zwei-, drei-, aber auch höherdimensional sein.

In einem darauffolgenden vierten Schritt erfolgt dann ein Vergleich dieses Merkmalsvektors mit einem vorgegebenen Referenzraum und führt zu einem entsprechenden Vergleichsergebnis. Die jeweiligen Referenzräume können ebenfalls ein-, zwei,- drei- oder höherdimensional sein, zweckmäßiger Weise jeweils entsprechend der Dimension des zu vergleichenden Merkmalsvektors.

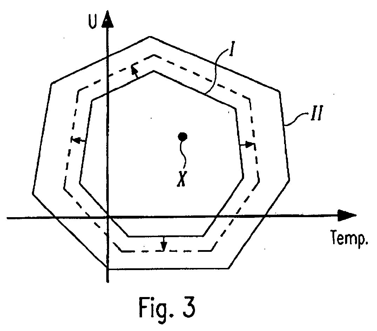

Ein Beispiel eines Vergleichs des Zusammenwirkens zweier physikalischer Messwerte mit einem vorgegebenen Referenzraum ist in Figur 3 dargestellt, wobei hier das Zusammenwirken zwischen einer an dem LED-Modul 10 anliegenden Spannung U mit der sich ergebenen Temperatur Temp an dem LED-Modul 10 überprüft wird. Im Rahmen der zuvor durchgeführten Messung wird also einerseits die an dem LED-Modul 10 vorliegende Temperatur sowie anderseits die vorliegende Spannung bestimmt. Dies ergibt in dem dargestellten Beispiel einen 2-dimensionalen Referenzraum mit einem dem Messergebnis entsprechenden Punkt bzw. Merkmalsvektor X, wobei überprüft wird, ob dieser Punkt X innerhalb eines vorgegebenen zulässigen Referenzraumes liegt oder außerhalb hiervon. Dieser Referenzraum ist im dargestellten Ausführungsbeispiel durch den durch die Kurve I abgegrenzten Bereich gekennzeichnet.

Liegt also der durch die Messungen bestimmte Wert X innerhalb dieses Bereichs I, so befindet sich im Rahmen dieses Vergleichs die zu bewertende Eigenschaft des LED-Moduls 10 in einem zulässigen Bereich. Bezüglich dieses Merkmalsvektors liegt also keine Abweichung vom Normzustand vor. Würde hingegen der Merkmalsvektor außerhalb des zulässigen Bereichs I liegen, so würde dies zumindest für diesen Merkmalsvektor auf einen Fehlzustand hindeuten, der möglicherweise zu einer Beeinträchtigung der Funktionsfähigkeit des Moduls insgesamt führen kann.

Im Rahmen dieses vierten Schritts werden also Eigenschaften des LED-Moduls, repräsentiert durch einen Merkmalsvektor, überprüft und bestimmt, ob ein oder mehrere diese Eigenschaften charakterisierende Parameter innerhalb oder außerhalb eines zulässigen Bereichs liegen. Dabei stellt das Beispiel in Figur 3, welches den Zusammenhang zwischen Spannung und Temperatur darstellt, einen denkbaren zu beurteilenden Merkmalsvektor X dar, da hier zwei bzw. allgemein eine Mehrzahl von Eigenschaften kombiniert betrachtet werden. Bei Beurteilung eines LED-Moduls könnte als weiterer Merkmalsvektor darüber hinaus auch der Zusammenhang zwischen Strom und Spannung beurteilt werden, um festzustellen, ob ein auf eine elektrostatische Entladung (ESD) zurückzuführender Schaden vorliegt. Denkbar wäre auch, das Zusammenwirken zwischen Leistung, Temperatur an dem Modul und Umgebungstemperatur zu beurteilen, was das Erkennen von evtl. Schäden an den Mitteln zum Abführen der während des LED-Betriebs entstehenden Wärme ermöglicht. Neben diesen soeben beschriebenen Merkmalsvektoren können allerdings andere Eigenschaften bzw. Merkmale auch isoliert betrachtet werden.

Die zuvor genannten Beispiele verdeutlichen, dass die jeweiligen Vergleiche mit Referenzräumen nicht nur für einzelne physikalische Parameter isoliert, also im 1-dimensionalen Raum durchgeführt werden, sondern dass auch ein Vergleich in höherdimensionalen Räumen, insbesondere in 2-dimensionalen oder 3-dimensionalen Räumen stattfinden kann. Jeder Vergleich eines Merkmalsvektors mit einem zugehörigen Referenzraum führt dann zu einem entsprechenden Vergleichsergebnis (z.B. in Form einer Kennzahl), welches Auskunft über die entsprechende Eigenschaft bzw. die entsprechende Kombination von Eigenschaften des LED-Moduls liefert.

Ferner ist darauf hinzuweisen, dass bei Durchführung des Vergleichs nicht unbedingt die gemessenen physikalischen Parameter bzw. Rohdaten herangezogen werden müssen. So können zuvor auch diese Messungen mathematisch ausgewertet bzw. analysiert werden und die sich hieraus ergebenen Erkenntnisse in den Vergleich einfließen. Beispielsweise ist es bei einer zeitabhängigen Messung eines Parameters oftmals sinnvoll, das entsprechende Ergebnis einer Fourier-Analyse zu unterziehen und die hieraus gewonnenen Frequenzeigenschaften des Parameters in den Vergleich einfließen zu lassen.

Eine Weiterbildung im Hinblick auf die zuvor beschriebenen Vergleiche kann ferner auch darin bestehen, dass nicht nur eine Aussage darüber getroffen wird, ob sich der erhaltene Messwert innerhalb oder außerhalb eines zulässigen Bereichs befindet, sondern ergänzend auch berücksichtigt wird, wie hoch der Abstand zum zulässigen Referenzraum ist, falls der Merkmalsvektor außerhalb hiervon liegt. Es wäre auch denkbar, den Idealzustand des Geräts als Punkt in einem Referenzraum festzulegen und die Bestimmung der Abweichung des Merkmalsvektors von dem vorgegebenen Sollwert in das Vergleichsergebnis einfließen zu lassen. Beispielsweise könnten auch abgestufte Referenzräume herangezogen werden, um eine detailliertere Aussage über das entsprechende Merkmal oder die Merkmalskombination des LED-Moduls zu erhalten, wobei dann ein maximal zulässiger Bereich (in Figur 3 dargestellt durch die Kurve II) angibt, innerhalb welchen Wertbereichs sich der entsprechende Merkmalsvektor auf jeden Fall befinden sollte. Liegt hingegen der Wert außerhalb dieses maximal zulässigen Bereichs II, so liegt definitiv ein entsprechender Fehler in dieser Eigenschaft vor.

Die Vergleichs- bzw. Referenzräume werden vorzugsweise zu Beginn festgelegt und repräsentieren den Idealzustand des LED-Moduls. Besonders zweckmäßig ist hier die Wahl einer möglichst niedrigen Dimension für die Referenzräume in der Phase der Modellbildung. Diese Referenzräume können dann, beispielsweise im Rahmen der Herstellung des Moduls bzw. unmittelbar nach dessen Herstellung festgelegt werden, wobei die hierfür erforderlichen Informationen im Rahmen von Messungen erhalten werden. Eine Weiterbildung des Gedankens wäre nunmehr dahingehend möglich, dass der Referenzraum im Laufe der Betriebszeit des LED-Moduls angepasst wird, wie dies durch die in Figur 3 gestrichelt dargestellte Kurve verdeutlicht wird. Dies kann beispielsweise sinnvoll sein, um sich im Laufe des Betriebs ergebene Alterserscheinungen, welche allerdings noch nicht auf einen Defekt des Moduls hindeuten, zu berücksichtigen. Dabei kann beispielsweise vorgesehen sein, dass eine entsprechende Anpassung bzw. Adaption des zulässigen Referenzraums nur während eines bestimmten Zeitraums, beispielsweise während der ersten 100 Betriebsstunden des LED-Moduls erfolgt.

Eine weitere Fortführung des Gedankens einer adaptiven Referenzraumfestlegung besteht darin, dass sich der Referenzraum unter bestimmten Umständen selbsttätig erweitert. Liegt beispielsweise ein zu vergleichender Merkmalsvektor außerhalb des vorgegebenen Referenzraums, so erkennt die Beurteilungseinheit 25 selbstständig ob eine Erweiterung um diesen Bereich zulässig ist und führt eine Neuberechnung und somit -festlegung des Referenzraums zur zukünftigen Verwendung durch.

Auf Basis dieser Vergleiche bzw. der im Rahmen der Vergleich ermittelten Kennzahlen wird dann letztendlich, in einem fünften Schritt eine Zustands-Information hinsichtlich des Zustands des LED-Moduls erstellt. Die Überwachungseinheit 25 weist hierzu intern eine entsprechende Bewertungseinheit auf, welche die Vergleichsergebnisse, ggf. unter Einfluss unterschiedlicher Gewichtung dieser, miteinander kombiniert, eine einzige Zustandskennzahl ermittelt und anhand dieser Zustandkennzahl den Zustand beurteilt. Selbstverständlich führt dabei eine Vielzahl von Vergleichsergebnissen, bei denen die entsprechenden Werte außerhalb des zulässigen Referenzraums liegen, zu einer negativen Beurteilung des Zustands des LED-Moduls. Die Tatsache hingegen, dass ein einzelner Vergleich negativ ausfällt, muss nicht zwangsläufig bereits auf einen Fehler des Moduls hindeuten. Wichtig ist, dass das Zusammenwirken der verschiedenen Vergleichsergebnisse in die endgültige Beurteilung des Zustands einfließt, wobei die Vergleichsergebnisse unterschiedlich stark gewichtet sein können. Hierbei wird jedoch keine komplexe Bewertung der Vergleichsergebnisse im Rahmen aufwendiger Algorithmen, die z.B. auf einem physikalischen Model des zu bewertenden Geräts beruhen, durchgeführt, sondern es erfolgt eine einfache numerische Bewertung dahingehend, dass überprüft wird, inwiefern die Vergleichsergebnisse bzw. die ermittelten Kennzahlen und die daraus ermittelte Zustandsinformation, die eine Fehlermöglichkeit anzeigen, auf einen bestimmten Zustand des Geräts hindeuten.

Eine Zustandsinformation kann insbesondere durch prozentuale Zuverlässigkeitsangaben, in der Angabe der erwarteten Lebenszeit oder auch durch absolute Angaben über den Zustand wie beispielsweise "OK" und "NOT OK" erfolgen.

Je nach Ergebnis dieser endgültigen Beurteilung kann dann vorgesehen sein, dass durch die Einheit 25 eine entsprechende Rückmeldung an das Betriebsgerät 20 oder die zentrale Steuereinheit 2 erfolgt. Die Einheit 25 weist - wie bereits erwähnt - hierzu entsprechende Mittel zur Kommunikation auf. Nach Erhalt einer Information, die auf einen sich anbahnenden Ausfall des Moduls hindeutet, können dann entsprechende Maßnahmen, insbesondere ein Austausch des Modules initiiert werden.

Durch die erfindungsgemäße Vorgehensweise können also deutlich detaillierte Informationen hinsichtlich des Betriebszustands des LED-Moduls erhalten werden. Auf diesem Wege kann verhindert werden, dass ein entsprechendes Modul überraschender Weise ausfällt und bis zu einer entsprechenden Wartungsarbeit unnötig viel Zeit vergeht. Dies ist insbesondere bei Leuchten, deren dauerhaft zuverlässige Funktion erforderlich ist, beispielsweise bei Notleuchten oder Rettungszeichenleuchten, von Vorteil.

Das zuvor beschriebene Konzept kann allerdings nicht nur bei der Beurteilung des Zustands von LED-Lichtquellen herangezogen werden sondern ist in vielfältiger Weise auf unterschiedlichste elektronische Komponenten anwendbar. So könnte in vergleichbarer Weise auch der Betriebszustand des Lampenbetriebsgeräts 20 überwacht werden. Auch alle Arten von Lichtquellen könnten auf diesem Wege beurteilt werden, wobei besonders Lichtquellen auf OLED-Basis hervorzuheben sind, da sich hier die gleiche Problematik wie bei LED-Lichtquellen ergibt, also bislang Fehler im Betriebszustand derartiger Lichtquellen erst nach deren endgültigem Ausfall erkannt werden konnten. Schließlich wäre es auch möglich, die Funktionalität entsprechender Bediengeräte oder Steuergeräte, mit deren Hilfe die Ansteuerung von Leuchten oder Lampenbetriebsgeräten erfolgt, in der erfindungsgemäßen Weise vorzunehmen.

## Patentansprüche

1. Anordnung (25) zur Beurteilung des Zustands einer zu Beleuchtungszwecken verwendeten elektronischen Einheit (10),
wobei die Anordnung (25) dazu ausgebildet ist,
a) mehrere, den aktuellen Zustand der elektronischen Einheit (10) repräsentierende physikalische Parameter zur erfassen,
b) die erfassten physikalischen Parameter nach ggf. mathematischer Auswertung oder Analyse allein oder in Kombination mit vorgegebenen Referenzwerten bzw. Referenzräumen (I, II) zu vergleichen,
c) auf Basis der Vergleiche eine den Zustand der zu beurteilenden elektronischen Einheit (10) beschreibende Information zu erstellen,
**dadurch gekennzeichnet,**
**dass** die zum Vergleichen herangezogenen Referenzwerte bzw. Referenzräume (I, II) zumindest teilweise abgestuft sind.

2. Anordnung nach Anspruch 1,
**dadurch gekennzeichnet,**
**dass** beim Erstellen der Zustands-Information die Vergleichsergebnisse unterschiedlich stark gewichtet werden.

3. Anordnung nach einem der vorherigen Ansprüche,
**dadurch gekennzeichnet,**
**dass** die zum Vergleichen herangezogenen Referenzwerte bzw. Referenzräume bei Herstellung bzw. unmittelbar nach Herstellung der zu beurteilenden elektronischen Einheit (10) vorzugsweise auf Basis von Messergebnissen festgelegt werden.

4. Anordnung nach einem der vorherigen Ansprüche,
**dadurch gekennzeichnet,**
**dass** die zum Vergleichen herangezogenen Referenzwerte bzw. Referenzräume (I, II) dauerhaft unverändert bleiben
oder
**dass** die Anordnung (25) dazu ausgebildet ist, die zum Vergleichen herangezogenen Referenzwerte bzw. Referenzräume (I, II) selbständig zu modifizieren,
wobei vorzugsweise das Modifizieren der Referenzwerte bzw. Referenzräume (I, II) innerhalb eines vorgegebenen Zeitraums nach Inbetriebnahme der zu bewertenden elektronischen Einheit (10) erfolgt.

5. Anordnung nach einem der vorherigen Ansprüche,
**dadurch gekennzeichnet,**
**dass** diese Mittel zum Messen der physikalischen Parameter aufweist
oder
**dass** die Anordnung dazu ausgebildet ist, mit Sensoren oder Messeinrichtungen zum Erfassen der physikalischen Parameter verbunden zu werden.

6. Anordnung nach einem der vorherigen Ansprüche,
**dadurch gekennzeichnet,**
**dass** es sich bei den erfassten physikalischen Parametern insbesondere um Temperatur-, Spannungs-, Strom-, Lichtstrom-, Helligkeits-, Farb-, Frequenz-, Zeitwerte und/oder spektrale Komponenten handelt.

7. Anordnung nach einem der vorherigen Ansprüche,
**dadurch gekennzeichnet,**
**dass** diese eine Schnittstelle zum Auslesen von Daten aufweist.

8. Anordnung nach einem der vorherigen Ansprüche,
**dadurch gekennzeichnet,**
**dass** diese integraler Bestandteil der zu beurteilenden elektronischen Einheit ist.

9. Anordnung nach einem der vorherigen Ansprüche,
**dadurch gekennzeichnet,**
**dass** es sich bei der zu beurteilenden elektronischen Einheit um ein Leuchtmittel, insbesondere um ein LED-Modul, ein OLED-Modul, eine Halogenlampe, eine Gasentladungslampe oder eine Leuchtstofflampe, ein Betriebsgerät zum Betreiben eines Leuchtmittel oder eines Bediengeräts zum Ansteuern von Leuchten bzw. Betriebsgeräten für Leuchtmittel handelt.

10. Verfahren zur Beurteilung des Zustands einer zu Beleuchtungszwecken verwendeten elektronischen Einheit (10), aufweisend:
a) Erfassen mehrerer, den aktuellen Zustand der elektronischen Einheit (10) repräsentierender physikalischer Parameter,
b) Vergleichen der erfassten physikalischen Parameter nach ggf. mathematischer Auswertung oder Analyse allein oder in Kombination mit vorgegebenen Referenzwerten bzw. Referenzräumen (I, II),
c) auf Basis der Vergleiche Erstellen einer den Zustand der zu beurteilenden elektronischen Einheit (10) beschreibenden Information,
**dadurch gekennzeichnet,**
**dass** die zum Vergleichen herangezogenen Referenzwerte bzw. Referenzräume (I, II) zumindest teilweise abgestuft sind.

11. Verfahren nach Anspruch 10,
**dadurch gekennzeichnet,**
**dass** beim Erstellen der Zustands-Information die Vergleichsergebnisse unterschiedlich stark gewichtet werden.

12. Verfahren nach einem der Ansprüche 10 bis 11,
**dadurch gekennzeichnet,**
**dass** die zum Vergleichen herangezogenen Referenzwerte bzw. Referenzräume bei Herstellung bzw. unmittelbar nach Herstellung der zu beurteilenden elektronischen Einheit (10) vorzugsweise auf Basis von Messergebnissen festgelegt werden.

13. Verfahren nach einem der Ansprüche 10 bis 12,
**dadurch gekennzeichnet,**
**dass** die zum Vergleichen herangezogenen Referenzwerte bzw. Referenzräume (I, II) dauerhaft unverändert bleiben
oder
**dass** die zum Vergleichen herangezogenen Referenzwerte bzw. Referenzräume (I, II) während der Betriebsdauer der elektronischen Einheit modifiziert werden,
wobei vorzugsweise das Modifizieren der Referenzwerte bzw. Referenzräume (I, II) innerhalb eines vorgegebenen Zeitraums nach Inbetriebnahme der zu bewertenden elektronischen Einheit (10) erfolgt.

14. Verfahren nach einem der Ansprüche 10 bis 13,
**dadurch gekennzeichnet,**
**dass** es sich bei den erfassten physikalischen Parametern insbesondere um Temperatur-, Spannungs-, Strom-, Lichtstrom-, Helligkeits-, Farb-, Frequenz-, Zeitwerte und/oder spektrale Komponenten handelt.

15. Verfahren nach einem der Ansprüche 10 bis 14,
**dadurch gekennzeichnet,**
**dass** es sich bei der zu beurteilenden elektronischen Einheit um ein Leuchtmittel, insbesondere um ein LED-Modul, ein OLED-Modul, eine Halogenlampe, eine Gasentladungslampe oder eine Leuchtstofflampe, ein Betriebsgerät zum Betreiben eines Leuchtmittel oder eines Bediengeräts zum Ansteuern von Leuchten bzw. Betriebsgeräten für Leuchtmittel handelt.

## Claims

1. Arrangement (25) to assess the status of an electronic unit used for lighting purposes (10),
wherein the arrangement (25) is designed to
a) detect a plurality of physical parameters representing the current status of the electronic unit (10),
b) compare the detected physical parameter in accordance with mathematical evaluation or analysis alone, or in combination with predetermined reference values or reference framework (I, II),
c) create descriptive information based on the comparison of a status of the electronic unit (10) being assessed,
**characterized in that**,
the reference values or reference framework (I, II) used for the comparison are at least partially graded.

2. Arrangement according to claim 1,
**characterized in that**,
the comparison results are weighted differently when creating the status information.

3. Arrangement according to one of the preceding claims, **characterized in that**,
the reference values or reference framework used for the comparison are preferably set during manufacture or immediately after manufacture of the electronic unit (10) being assessed.

4. Arrangement according to one of the preceding claims, **characterized in that**,
the reference values or reference framework (I, II) used for the comparison remain permanently unchanged, or
the arrangement (25) is designed to modify independently the reference values or reference framework (I, II) used for the comparison,
wherein the modification of the reference values or reference framework (I, II) is preferably carried out within a predetermined period after start-up of the electronic unit (10) to be assessed.

5. Arrangement according to one of the preceding claims, **characterized in that**,
this comprises means for measuring the physical parameters, or
the arrangement is designed to be connected to sensors or measuring devices for detecting the physical parameters.

6. Arrangement according to one of the preceding claims, **characterized in that**,
the physical parameters to be detected relate in particular to temperature, voltage, current, luminous flux, luminance, colour, frequency, time values and/or spectral components.

7. Arrangement according to one of the preceding claims, **characterized in that**, this has an interface for reading out data.

8. Arrangement according to one of the preceding claims, **characterized in that**, this is an integral part of the electronic unit to be assessed.

9. Arrangement according to any one of the preceding claims, **characterized in that**,
the electronic unit to be assessed relates to a luminaire, in particular an LED module, an OLED module, a halogen lamp, a gas discharge lamp or a fluorescent lamp, an operating device for operating a lighting means, or an operating device for controlling luminaires or operating devices for lighting means.

10. Method for assessing the status of an electronic unit used for illumination purposes (10), comprising:
a) detection of a plurality of physical parameters representing the current status of the electronic unit (10),
b) comparison of the detected physical parameters in accordance with mathematical evaluation or analysis alone, or in combination with predetermined reference values or reference framework (I, II),
c) creation of descriptive information based on the comparison of a status of the electronic unit (10) being assessed,
**characterized in that**,
the reference values or reference framework (I, II) used for the comparison are at least partially graded.

11. Method according to claim 10,
**characterized in that**,
the comparison results are weighted differently when creating the status information.

12. Method according to any one of the claims 10 to 11,
**characterized in that**,
the reference values or reference framework used for the comparison are preferably set during manufacture or immediately after manufacture of the electronic unit (10) being assessed.

13. Method according to one of the claims 10 to 12,
**characterized in that**,
the reference values or reference framework (I, II) used for the comparison remain permanently unchanged, or
the reference values or reference framework (I, II) used for the comparison are modified during the service life,
wherein the modification of the reference values or reference framework (I, II) is preferably carried out within a predetermined period after start-up of the electronic unit (10) to be assessed

14. Method according to one of the claims 10 to 13,
**characterized in that**,
the physical parameters to be detected relate in particular to temperature, voltage, current, luminous flux, luminance, colour, frequency, time values and/or spectral components.

15. Method according to one of the claims 10 to 14,
**characterized in that**,
the electronic unit to be assessed relates to a luminaire, in particular an LED module, an OLED module, a halogen lamp, a gas discharge lamp or a fluorescent lamp, an operating device for operating a lighting means, or an operating device for controlling luminaires or operating devices for lighting means.

## Revendications

1. Dispositif (25) pour l'évaluation de l'état d'une unité électronique (10) utilisée pour un éclairage,
le dispositif (25) étant conçu pour :
a) déterminer plusieurs paramètres physiques représentatifs de l'état actuel de l'unité électronique (10),
b) comparer les paramètres physiques déterminés, après une éventuelle analyse mathématique, seuls ou en combinaison avec des valeurs de référence ou des plages de référence (I, II) prédéterminées,
c) sur la base des comparaisons, générer des informations décrivant l'état de l'unité électronique (10) à évaluer,
**caractérisé en ce que**
les valeurs de référence ou les plages de référence (I, II) utilisées pour les comparaisons sont au moins partiellement échelonnées.

2. Dispositif selon la revendication 1,
**caractérisé en ce que**
lors de la génération des informations d'état, les résultats des comparaisons sont pondérées différemment.

3. Dispositif selon l'une des revendications précédentes,
**caractérisé en ce que**
les valeurs de référence ou les plages de référence utilisées pour les comparaisons sont fixées lors de la fabrication ou immédiatement après la fabrication de l'unité électronique (10) à évaluer.

4. Dispositif selon l'une des revendications précédentes,
**caractérisé en ce que**
les valeurs de référence ou les plages de référence (I, II) utilisées pour les comparaisons restent durablement inchangées
ou
**en ce que** le dispositif (25) est conçu pour modifier automatiquement les valeurs de référence ou les plages de référence (I, II) utilisées pour les comparaisons,
de préférence la modification des valeurs de référence ou des plages de référence (I, II) ayant lieu à l'intérieur d'une période prédéterminée après la mise en service de l'unité électronique (10) à évaluer.

5. Dispositif selon l'une des revendications précédentes,
**caractérisé en ce que**
celui-ci comprend des moyens pour la mesure des paramètres physiques
ou
**en ce que** le dispositif est conçu pour être utilisé avec des capteurs ou des dispositifs de mesure permettant de déterminer les paramètres physiques.

6. Dispositif selon l'une des revendications précédentes,
**caractérisé en ce que**
les paramètres physiques déterminés sont plus particulièrement des valeurs de température, de tension de courant, de flux lumineux, de luminosité, de couleur, de fréquence, de temps et/ou des composantes spectrales.

7. Dispositif selon l'une des revendications précédentes,
**caractérisé en ce que**
celui-ci comprend une interface pour la lecture de données.

8. Dispositif selon l'une des revendications précédentes,
**caractérisé en ce que**
celui-ci fait partie intégrante de l'unité électronique à évaluer.

9. Dispositif selon l'une des revendications précédentes,
**caractérisé en ce que**
l'unité électronique à évaluer est un luminaire, plus particulièrement un module à LED, un module à OLED, une lampe halogène, une lampe à décharge de gaz ou une lampe fluorescente, un appareil d'actionnement pour l'actionnement d'un luminaire ou d'un appareil de commande pour la commande de lampes ou des appareils d'actionnement pour des luminaires.

10. Procédé pour l'évaluation de l'état d'une unité électronique (10) utilisée pour un éclairage, comprenant:
a) la détermination de plusieurs paramètres physiques représentatifs de l'état actuel de l'unité électronique (10),
b) la comparaison des paramètres physiques déterminés, après une éventuelle analyse mathématique, seuls ou en combinaison avec des valeurs de référence ou des plages de référence (I, II) prédéterminées,
c) sur la base des comparaisons, la génération d'informations décrivant l'état de l'unité électronique (10) à évaluer,
**caractérisé en ce que**
les valeurs de référence ou les plages de référence (I, II) utilisées pour les comparaisons sont au moins partiellement échelonnées.

11. Procédé selon la revendication 10,
**caractérisé en ce que**
lors de la génération des informations d'état, les résultats des comparaisons sont pondérés différemment.

12. Procédé selon l'une des revendications 10 à 11,
**caractérisé en ce que**
les valeurs de référence ou les plages de référence utilisées pour les comparaisons sont fixées lors de la fabrication ou immédiatement après la fabrication de l'unité électronique (10) à évaluer.

13. Procédé selon l'une des revendications 10 à 12,
**caractérisé en ce que**
les valeurs de référence ou les plages de référence (I, II) utilisées pour les comparaisons restent durablement inchangées
ou
**en ce que** les valeurs de référence ou les plages de référence (I, II) utilisées pour les comparaisons sont modifiées pendant la durée de fonctionnement de l'unité électronique,
de préférence la modification des valeurs de référence ou des plages de référence (I, II) ayant lieu à l'intérieur d'une période prédéterminée après la mise en service de l'unité électronique (10) à évaluer.

14. Procédé selon l'une des revendications 10 à 13,
**caractérisé en ce que**
les paramètres physiques déterminés sont plus particulièrement des valeurs de température, de tension de courant, de flux lumineux, de luminosité, de couleur, de fréquence, de temps et/ou des composantes spectrales.

15. Procédé selon l'une des revendications 10 à 14,
**caractérisé en ce que**
l'unité électronique à évaluer est un luminaire, plus particulièrement un module à LED, un module à OLED, une lampe halogène, une lampe à décharge de gaz ou une lampe fluorescente, un appareil d'actionnement pour l'actionnement d'un luminaire ou d'un appareil de commande pour la commande de lampes ou des appareils d'actionnement pour des luminaires.
